# EUROPÄISCHE PATENTSCHRIFT

(11) **EP 1 129 485 B1**
(45) Veröffentlichungstag und Bekanntmachung des Hinweises auf die Patenterteilung: **21.03.2007**
(21) Anmeldenummer: 00907422.0
(22) Anmeldetag: 13.01.2000
(51) Int. Cl.: H01L 27/02, G06K 9/00, H01L 23/485

(54) **ELEKTRONISCHES BAUELEMENT UND VERWENDUNG EINER DARIN ENTHALTENEN SCHUTZSTRUKTUR**
ELECTRONIC COMPONENT AND USE OF A PROTECTIVE STRUCTURE CONTAINED THEREIN
COMPOSANT ELECTRONIQUE ET UTILISATION D'UNE STRUCTURE DE PROTECTION A L'INTERIEUR DUDIT COMPOSANT

(30) Priorität: 15.01.1999 DE 19901384
(43) Veröffentlichungstag der Anmeldung: 05.09.2001
(73) Patentinhaber: Infineon Technologies AG, 81669 München (DE)
(72) Erfinder: OPOLKA, Heinz, D-93509 Regensburg (DE); VON BASSE, Paul-Werner, D-82515 Wolfratshausen (DE); SCHEITER, Thomas, D-82041 Oberhaching (DE); GROSSMANN, Rainer, D-81739 München (DE); PETERS, Christian, D-81667 München (DE); FISCHBACH, Reinhard, D-93049 Regensburg (DE); GAYMANN, Andreas, D-81541 München (DE); ROSTECK, Thomas, D-83624 Otterfing (DE); SIPRAK, Domagoj, D-93051 Regensburg (DE); SASSE, Thorsten, D-93049 Regensburg (DE); GÖLLNER, Reinhard, D-93049 Regensburg (DE); BIERNER, Justin, D-92242 Hirschau (DE); MELZL, Michael, D-93073 Neutraubling (DE); HAMMER, Klaus, D-93149 Nittenau/Fischbach (DE); WITTE, Markus, D-93051 Regensburg (DE)
(74) Vertreter: Epping - Hermann - Fischer
(86) Internationale Anmeldenummer: PCT/DE2000/000112
(87) Internationale Veröffentlichungsnummer: WO 2000/042657

(56) Entgegenhaltungen:
- EP-A- 0 902 387
- WO-A-98/52157
- US-A- 5 325 442
- US-A- 5 726 481
- US-A- 5 801 095

## Beschreibung

Die Erfindung bezieht sich auf ein elektronisches Bauelement und die Verwendung einer in dem elektronischen Bauelement vorgesehenen Schutzstruktur als Schutz gegen elektrostatische Entladung. Bisher wurden üblicherweise elektronische Bauelemente innerhalb eines Gehäuses vorgesehen, aus denen Zuführleitungen zum Zuführen der Energieversorgung bzw. zum Zuführen und/oder Abführen von Signalen herausführen. Bei diesen elektronischen Bauelementen, sind insbesondere die, die einen Halbleiterchip im Inneren des Gehäuses enthalten, der in sog. CMOS-Technologie hergestellt ist, sehr empfindlich gegen elektrostatische Entladung. Dabei kommt es im Bauelement durch von außen auf das Bauelement einwirkende Potentialdifferenzen zu Ladungsverschiebungen, die letztendlich zu einer Überspannung an einem oder mehreren der sog. Gate-Kondensatoren führt, so daß es hier zu einer direkten Entladung zwischen den einzelnen Platten des genannten Gate-Kondensators kommt, was in der Regel zur Zerstörung des Bauelementes führt. Zu einer solchen elektrostatischen Aufladung, die sich dann zerstörend entlädt kann es beispielsweise durch Berührung kommen und hiergegen schützt man sich in Elektroniklabors beispielsweise dadurch, daß die Bauelemente auf einem leitenden Moosgummi gelagert werden. Weiterhin tragen häufig Personen, die mit diesen Bauelementen in Elektroniklabors in Berührung kommen entsprechende Erdungsbänder, so daß durch Berührung keine Aufladung entstehen kann. Für die Fertigung mittels Bestückungsanlagen, bei der die Bauelemente auf Leiterplatten montiert werden sind entsprechende Vorkehrungen vorgesehen.

Sind die Bauelemente erst einmal in einer Schaltung eingebaut, so besteht in der Regel nur noch eine geringe Gefahr, das Bauelement durch elektrostatische Entladung zu zerstören. Dies kann jedoch stets durch Schaltungsfehler oder durch Defekte anderer Bauelemente erfolgen. Um dies zu vermeiden weisen elektronische Bauelemente in der Regel zusätzliche schaltungstechnische Schutzstrukturen auf, so daß ein Schutz sowohl gegen elektrostatische Entladungen (ESD-Schutz) als auch gegen zugeführte Überspannungen besteht. Dies sind in der Regel Überspannungen abführender Schaltungen.

Ein grundsätzlicher Nachteil eines solchen ESD-Schutz ist es, daß er "Chip-Fläche kostet", die für die eigentliche Funktionalität des elektronischen Bauelementes nichts beiträgt. Ein weiterer Nachteil eines solchen ESD-Schutz ist es, daß durch ihn häufig die Funktionalität des Bauelementes ohne diesen ESD-Schutz verändert wird. Es erfolgt durch den ESD-Schutz häufig eine Rückwirkung auf Empfindlichkeit und/oder Dynamik des Bauelementes.

Neue elektronische Bauelemente weisen heute kein geschlossenes Gehäuse auf, so daß Teile des Halbleiterchips nach Außen freiliegen. Diese neuen elektronischen Bauelemente sind beispielsweise sog. "Chip sizes packages" (CSP), bei denen der Chip mit seinen Kontakten direkt auf einer Leiterplatte montiert wird. Weiterhin werden auch diverse Sensoren zunehmend als Halbleiterbauelemente hergestellt. Sowohl bei CSP als auch bei der Verwendung als Sensor weist das Bauelement insgesamt oder zumindest eine anteilsmäßig verhältnismäßig große Fläche gegenüber der Umwelt frei zugänglich auf.

In diesen Fällen kommt zu einem verstärkten Bedarf an Schutzmaßnahmen gegen elektrostatische Entladung. Solche Bauelemente sind auch Fingerabdrucksensoren, die aus einer Matrix aus vielen einzelnen Kapazitäten bestehen. Es ist vorgesehen, daß der Finger, von dem ein Abdruck abgenommen werden soll, direkt das Bauelement berührt. Besonders in einem solchen Fall kann es leicht zu einer statischen Aufladung kommen, da im Normalgebrauch eines solchen Sensors es nicht akzeptable ist, wenn der Finger vor dem Gebrauch zur Entladung geerdet werden muß. Auch bei mobilen Geräten, bei denen ein Fingerabdrucksensor vorgesehen ist, beispielsweise bei einem Handy, bleibt die Gefahr, daß es durch das Herumtragen des Gerätes zu einer elektrostatischen Aufladung kommt.

Aus der WO 98/52157 ist eine Fingerabdrucksensoreinrichtung bekannt, bei der eine elektrisch leitende Schicht unter einer Masseplatte angeordnet ist.

Weiterhin ist aus der US 5,325,442 bekannt, in Zwischenräumen zwischen leitenden Platten in Längsrichtung eine geerdete streifenförmige leitende Schicht anzuordnen, die vor elektrostatischen Entladungen schützen soll. Gleiches gilt für die EP 09 02 387 A2 (nachveröffentlicht)

Der Erfindung liegen nunmehr die Aufgabe zugrunde, ein elektronisches Bauelement vorzusehen, bei dem auch dann, wenn ein beachtlicher Teil nicht von einem Gehäuse umgeben ist, ein sicherer ESD-Schutz vorgesehen ist. Diese Aufgabe wird erfindungsgemäß mit den im Patentanspruch 1 bzw. 7 angegebenen Mitteln gelöst.

Durch das Vorsehen einer elektrisch leitenden Schutzstruktur, die in einer Ebene oberhalb leitfähiger Flächen angeordnet ist, und die leitenden Flächen frei läßt, ist sichergestellt, daß durch geeigneten Anschluß der leitfähigen Schutzstruktur diese die Wirkung eines Faradayschen Käfig hat. Dadurch ist auf einfache Weise ein Schutz gegen elektrostatische Entladung gesichert.

Weitere vorteilhafte Ausgestaltungen sind in den Unteransprüchen angegeben.

Durch das Vorsehen eines Zwischenraumbereiches, erfolgt keine Abdeckung der leitenden Flächen durch die Schutzstruktur. Das streifenförmige, schräge Ausbilden der Schutzstruktur führt zu auf die Zwischenraumbereiche gerichtete, nicht flächenhaft ausgebildete Enden, die die Wirkung eines Blitzableiters aufweisen.

Durch die Verwendung von Wolfram zur Herstellung der Schutzstruktur, ist diese von hoher Beständigkeit.

Das Ausbilden der Schutzstruktur in einer Strukturbreite von 1µm - 5µm ist besonders gut handhabbar. Weiterhin verbindet die Ausbildung einer gitterförmigen Schutzstruktur die leichte Herstellbarkeit mit der hohen Wirksamkeit als ESD-Schutz bei minimiertem Materialbedarf.

Nachfolgend wird die Erfindung unter Bezugnahme auf die Zeichnungen anhand von Ausführungsbeispielen erläutert. Es zeigen:
- Fig. 1: ein erstes erfindungsgemäßes Ausführungsbeispiel,
- Fig. 2: ein zweites erfindungsgemäßes Ausführungsbeispiel,
- Fig. 3: die in Fig. 1 und 2 dargestellten Ausführungsbeispiele in einer Draufsicht,
- Fig.4: eine vorteilhafte Ausgestaltung des in Fig. 1 dargestellten Ausführungsbeispiels,
- Fig. 5: eine weitere vorteilhafte Ausgestaltung des in Fig. 1 dargestellten Ausführungsbeispiels, und
- Fig. 6: wesentliche Verfahrensschritte zur Herstellung des erfindungsgemäßen elektronischen Bauelements.

In der nachfolgenden Beschreibung geben gleiche Bezugszeichen gleiche Teile an.

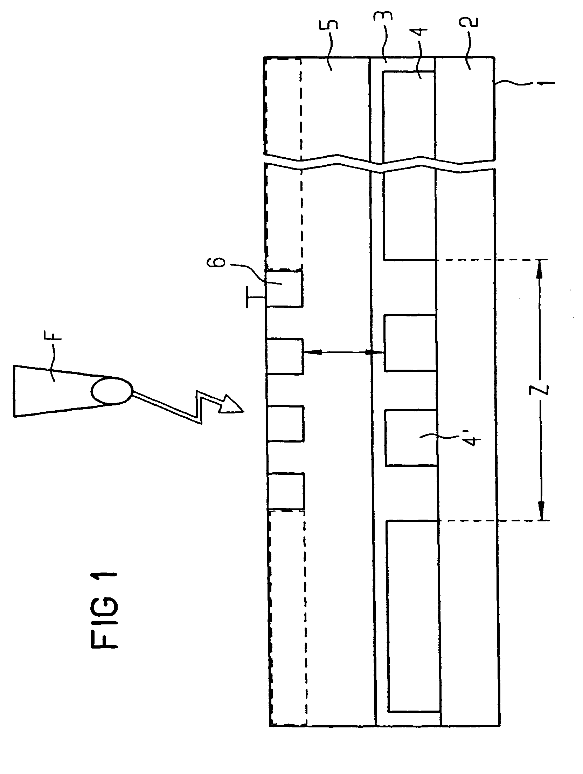

In Fig. 1 ist schematisch das erfindungsgemäße elektronische Bauelement dargestellt. Hierbei befindet sich auf der Oberfläche 1 eines Halbleiterchips eine dielektrische Schicht 2, die zum Trennen aktiver bzw. leitender Strukturen von Kontaktflächen bzw. darüber liegenden leitenden Flächen vorgesehen ist. Eine solche leitende Fläche 4 bzw. 4' ist im dargestellten Ausführungsbeispiel auf der dielektrischen Schicht 2 direkt ausgebildet, wobei Zwischenräume zwischen den elektrisch leitenden Flächen 4 bzw. 4' mit einem Oxid 3 ausgefüllt sind, das die elektrisch leitenden Flächen 4 bzw. 4' auch von der darüber liegenden Nitridschicht 5 trennt.

In dem dargestellten Ausführungsbeispiel sollen die elektrisch leitenden Flächen 4 einzelne Sensorelemente eines Fingerabdrucksensors sein. Dabei stellen die elektrisch leitenden Flächen 4 jeweils eine Kondensatorfläche dar, während der Finger als solches die gegenüberliegende Kondensatorfläche bildet. Die elektrisch leitenden Flächen 4' sind beispielsweise Leitungen, wobei die Anschlüsse nicht dargestellt sind. Auf dem Oxid 3 ist wiederum eine Nitridschicht 5 ausgebildet, die auch aus mehreren Schichten aufgebaut sein kann. In der Nitridschicht 5 sind Ausnehmungen vorgesehen, die mit Wolfram ausgefüllt sind. Nunmehr ist die Anordnung so ausgebildet, daß ein Finger F, dessen Abdruck abgetastet werden soll, und der auf die Oberfläche dieser Struktur aufgelegt werden soll, mit den elektrisch leitenden Flächen 4 weiterhin einen Kondensator bildet, da die Wolframstruktur 6 in Zwischenraumbereichen Z, zwischen den elektrisch leitenden Flächen 4 angeordnet ist. Ist der Finger F elektrisch aufgeladen, so wird dieser entladen, wenn die Wolframstruktur 6 geerdet ist, wie in Fig. 1 angedeutet ist.

Bei dem dargestellten Ausführungsbeispiel weist der Fingerabdrucksensor eine geeignete Struktur auf, bei der das die leitenden Flächen 4 umgebene Oxid eine Dicke von ca. 250 nm, das Nitrid eine Dicke von 1500 nm aufweist, die Tiefe der Ausnehmungen für die Wolframstruktur 6 bei ca. 370 bis 700 nm liegt, und die Breite der Ausnehmungen ca. 1µm beträgt.

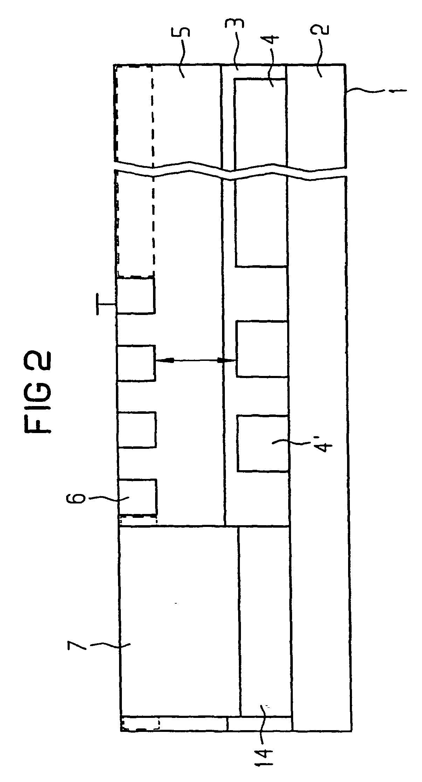

In Fig. 2 ist die Verwendung der Wolframstruktur 6 bei einem elektronischen Bauelement zur Oberflächenmontage wie beim CSP dargestellt. Hierbei ist eine leitende Fläche 14, die in einem Oxid ausgebildet ist zur Oberfläche hin durch das schützenden Nitrid 5 hindurch freigelegt. Die sich somit bildende Öffnung 7 dient der Kontaktierung der als Kontakt-Pad dienenden leitenden Flächen 14 bei der Oberflächenmontage auf eine Leiterplatte. Dabei wird dann die Öffnung 7 mit einem Lot oder einem Leitkleber ausgefüllt. Auch hier ist an der Oberfläche die Wolframstruktur 6 ausgebildet, der sich bei üblicher Verwendung im montierten Zustand kein aufgeladener Finger nähern wird, jedoch ist es auch im üblichen Betrieb eines als CSP montierten Bauelementes leicht möglich, daß es auf der Oberfläche der Leiterplatte zu einer elektrostatischen Aufladung kommt. Die leitende Schutzstruktur 6, die auch im dargestellten Ausführungsbeispiel als Wolframstruktur ausgebildet ist, dient auch hier, wenn sie geerdet ist als Schutz gegen elektrostatische Entladung. Sie wirkt sozusagen für das Bauelement als Faradayscher Käfig. Es ist die Verwendung von Wolfram nicht zwingend vorgegeben, gegenüber anderen zur Zeit in der Halbleitertechnik verwendeten AL-Legierungen weist Wolfram jedoch eine um den Faktor 6 erhöhte maximale Stromdichte auf und auch der Schmelzpunkt von Wolfram liegt mit 3410°C deutlich über dem einer üblichen Aluminiumlegierung (AlSiCu/660°C).

Sowohl in Fig. 1 als auch in Fig. 2 ist die Wolframstruktur 6 oberhalb leitender Flächen 4' ausgebildet, die in der gleichen Ebene wie die leitenden Flächen 4 liegen. Dies ist so gewählt, weil die leitenden Flächen 4' nicht von Außen zugänglich sein müssen.

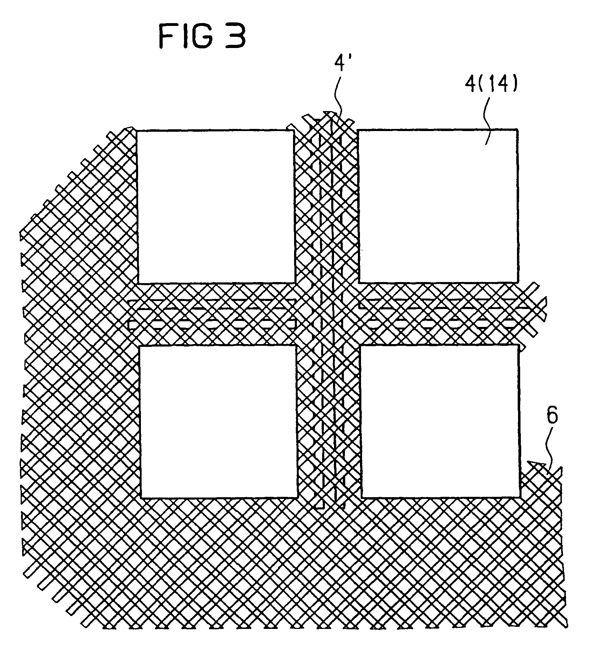

Dies ist nochmal in Fig. 3 von oben her betrachtet dargestellt. Hier sind die leitenden Flächen 4 bzw. 14 dargestellt. Es ist in dieser Darstellung auf Abdeckschichten verzichtet. D.h. man sieht die leitenden Flächen 4 als Kontaktflächen 14, wie unter Bezugnahme auf Fig. 2 beschrieben, genauso wie als Kondensatorplatte 4, unter Bezugnahme auf Fig. 1 beschrieben. Zwischen diesen leitenden Flächen 4 bzw. 14 ist die leitende Wolframstruktur 6 von oben gesehen gitterförmig ausgebildet, wobei sie zu den Seitenflächen der leitenden Flächen 4 bzw. 14 schräg ausgerichtet ist. Durch die Gitterbildung, und dadurch daß das Gitter die leitenden Flächen 4 bzw. 14 nicht abdeckt, bilden sich an den Rändern in der Struktur Vorsprünge bzw. Spitzen, die besonders gut zum Schutz gegen elektrostatische Entladung geeignet sind. Diese Gitterstruktur hat somit an den Rändern zu den leitenden Flächen 4 hin, eine ähnliche Wirkung wie Blitzableiter. Zwischen den leitenden Flächen 4 bzw. 14 sind die, wie schon in Fig. 1 und 2 dargestellten leitenden Flächen 4' dargestellt, die von dem Wolframgitter 6 abgedeckt sind, da die leitenden Flächen 4' nicht nach oben zugänglich sein müssen.

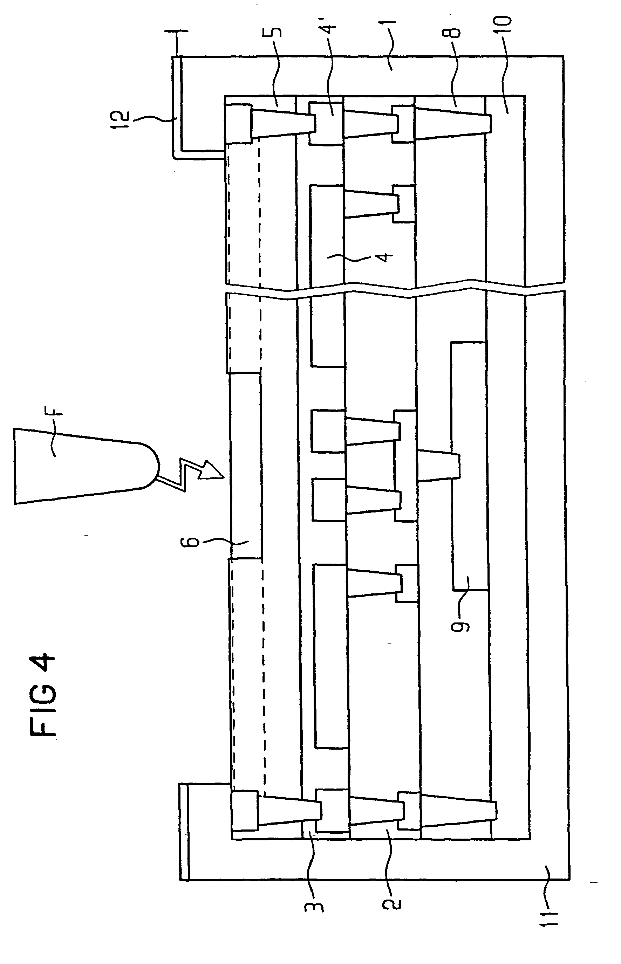

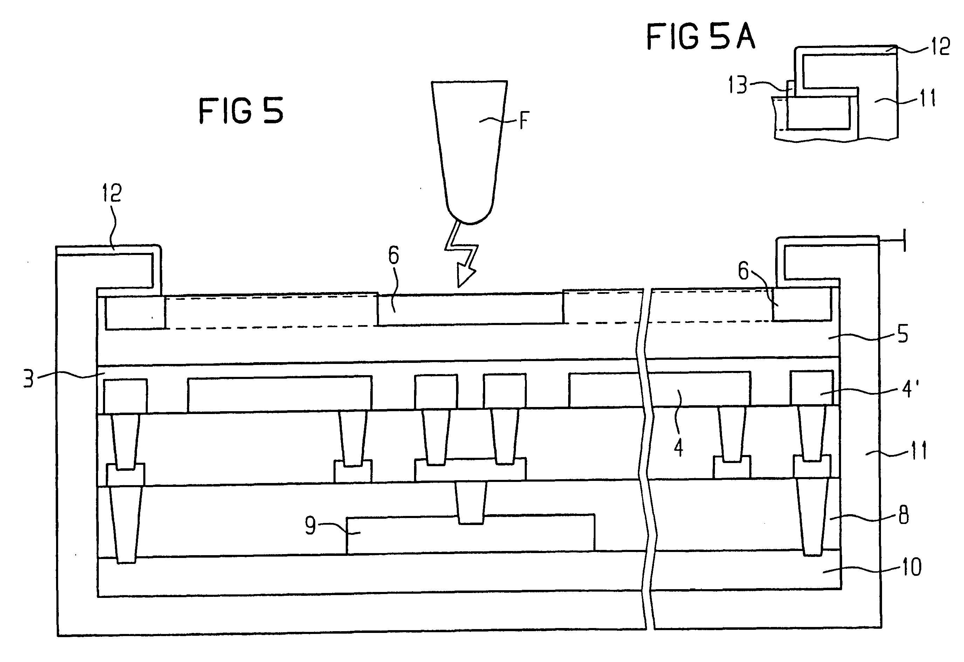

Unter Bezugnahme auf Fig. 4 bzw. 5 ist eine vorteilhafte Ausgestaltung der Erfindung insbesondere als Fingerabdrucksensor dargestellt. Dabei sind gleiche Elemente mit gleichen Bezugszeichen versehen. Der Fingerabdrucksensor, der in einem Ausschnitt dargestellt ist, besteht aus einem Substrat 10, an dessen Oberfläche eine aktive Struktur in Form einer integrierten Schaltung ausgebildet sein kann, aber für die vorliegende Erfindung nicht notwendiger Weise vorhanden sein muß. Darüber befindet sich auf einem Teil der Substratoberfläche eine Struktur aus Polysilizium 9, die wiederum mit einer Bohr-Phosphor-Silizium-Oxid-Glasschicht 8 abgedeckt ist. Darüber befindet sich eine erste Metallisierungslage mit nicht näher bezeichneten Metallisierungsbahnen, die von einer dielektrischen Schicht 2 abgedeckt ist. Dies ist die selbe dielektrische Schicht, wie sie bereits aus der Darstellung nach Fig. 1 bzw. Fig. 2 bekannt ist. Auch die darüberliegende Struktur entspricht der Struktur nach Fig. 1 bzw. Fig. 2. Das ganze Bauelement wiederum ist von einem Gehäuse 11 umgeben, das eine Oberfläche des Bauelementes freiläßt, dabei aber am Rand so herumgezogen ist, daß es auch auf der Oberfläche aufliegt.

Gemäß Fig. 4 sind von der Oberfläche Durchkontaktierungen durch alle zuvor beschriebenen Schichten bis zum Substrat vorgesehen, das mit Masse verbunden ist. Der an der Oberfläche liegende Teil der Durchkontaktierung ist wiederum mit der Wolframstruktur 6 elektrisch verbunden. Auf diese Weise ist, ebenfalls eine Anordnung, die einem Faradayschen Käfig entspricht vorgesehen. Der die freiliegende Chipfläche umgebende Rahmen des Gehäuses 11 ist mit einem Masserahmen 12 versehen.

Im Unterschied hierzu ist nach Fig. 5 keine Durchkontaktierung durch alle Schichten vorgesehen. Bei dem hier dargestellten Ausführungsbeispiel ist die Wolframstruktur 6 elektrisch leitend mit dem Masserahmen 12 verbunden. Ansonsten sind wieder die darunter liegenden Strukturen untereinander im Randbereich durchkontaktiert und es erfolgt dann die Masseverbindung über das Substrat. Auch in diesem dargestellten Ausführungsbeispiel ist auf diese Weise ein Faradayscher Käfig vorgesehen.

In Abwandlung des in Fig. 5 dargestellten Ausführungsbeispiels, kann die Verbindung zwischen dem Masserahmen und der Wolframstruktur 6 auch über einen Leitkleber erzeugt werden. Hierzu muß nicht, wie in Fig. 5 dargestellt, der Masserahmen 12 soweit herumgezogen werden, daß er auf der Wolframstruktur 6 aufliegt. Es reicht aus, die Anordnung-des Masserahmens 12, ähnlich wie in Fig. 4 dargestellt, über eine Leitkleberverbindung 13 im Näherungsbereich (siehe hierzu Fig. 5a) mit der Wolframstruktur 6 zu verbinden.

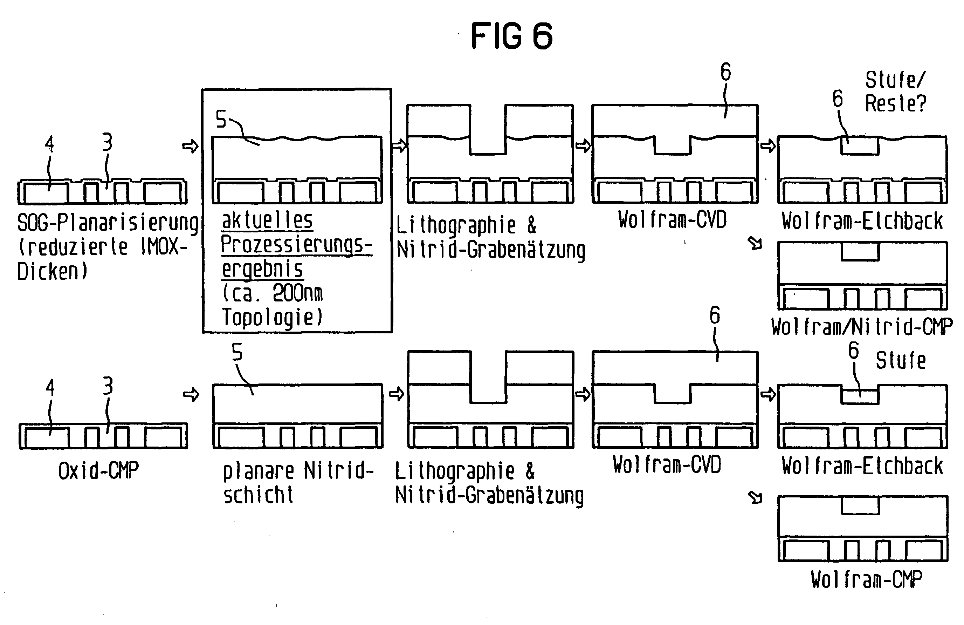

Gemäß Fig. 6 ist schematisch die Herstellung der Wolframstruktur dargestellt. Es erfolgt zunächst eine Planarisierung der Struktur, die sich aus den leitenden Flächen 4, bzw. 14 bzw. 4' und dem diese Flächen umgebenen Oxid 3 ergibt. Auf dieser Struktur wird das Nitrid aufgetragen, das lithographisch behandelt wird, worauf anschließend eine Nitridgrabenätzung zur Ausbildung der zuvor beschriebenen Ausnehmungen durchgeführt wird. Anschließend wird mittels eines CVD-Prozeßschrittes (Chemical Vapor Deposition) Wolfram aufgetragen. Das so ganzflächig aufgetragene Wolfram wird wiederum bis auf die Höhe der Nitridschicht abgetragen. Wobei die in I und II dargestellten, unterschiedlichen Abtragungsverfahren zu unterschiedlicher Welligkeit der Struktur führen. Im unteren Teil von Fig. 6 ist im Gegensatz zum oberen Teil die Ausgangsstruktur aus den leitenden Flächen und dem die leitenden Flächen umgebenen Oxid so eben, daß sich auch eine ebene Nitridschicht ausbildet.

Für die Wolframstruktur kann je nach verwendeter Technologie eine Strukturbreite zwischen 1 und 10µm vorgesehen sein. Bei CSP-Bauelementen, die nicht dem Extremfall, daß ein elektrostatisch aufgeladener Finger sich der Oberfläche nähert, ausgesetzt sind, kann es auch sinnvoll sein, keine Gitterstruktur auszubilden, sondern daß einfach ein Teil der Oberfläche ganzflächig mit Wolfram abgedeckt ist.

Die zuvor beschriebene Erfindung ist jedoch nicht nur auf Halbleiterbauelemente beschränkt. Sie ist im gleichen Maße auf zukünftige Technologien, wie elektronische Schaltungen in Polymerschalter-Technik anwendbar. Die Erfindung ist insbesondere dann von Vorteil, wenn diese Bauelemente freizugänglich wie Sensoren sind, wobei Fingerabdrucksensoren nur ein Beispiel sind. Eine solche Anwendung läßt sich schon jetzt beispielsweise für den Einsatz auf Chipkarten voraussagen, wo der Wunsch nach widerstandsfähigen, elastischen und gegen Umwelteinflüsse geschützten Fingerabdrucksensoren besteht, um die Identität des Benutzers zuverlässig feststellen zu können.

## Patentansprüche

1. Elektronisches Bauelement mit einer auf einem Substrat (10) ausgebildeten dielektrischen Schicht (2), leitenden Flächen (4; 14), die auf der dielektrischen Schicht ausgebildet sind, und einer elektrisch leitenden Schutzstruktur (6), die in einer Ebene oberhalb der leitenden Flächen (6) so angeordnet ist, daß die leitenden Flächen (4; 14) nicht von der Schutzstruktur (6) vollständig abgedeckt sind, die Schutzstruktur (6) entlang von Zwischenraumbereichen (Z), die zwischen den leitenden Flächen (4; 14) ausgebildet sind, angeordnet ist, **dadurch gekennzeichnet, daß** die Schutzstruktur (6) streifenförmig schräg zu einer Ausbreitungsrichtung des Zwischenraumbereichs (Z) verläuft.

2. Elektronisches Bauelement nach Anspruch 1, bei dem am Rand des Zwischenraumbereichs (Z) sich die Verlaufsrichtung der streifenförmigen Schutzstruktur (6) so ändert, daß der Zwischenraumbereich (Z) nicht verlassen wird, oder am Rand des Zwischenraumbereichs (Z) ändert.

3. Elektronisches Bauelement nach einem der vorhergehenden Ansprüche, bei dem die Schutzstruktur (6) aus Wolfram ausgebildet ist.

4. Elektronisches Bauelement nach einem der vorhergehenden Ansprüche, bei dem die Schutzstruktur (6) eine Strukturbreite von 1µm bis 5µm aufweist.

5. Elektronisches Bauelement nach einem der vorhergehenden Ansprüche, bei dem die Schutzstruktur (6) gitterförmig ausgebildet ist.

6. Elektronisches Bauelement nach einem der vorhergehenden Ansprüche, bei dem eine der leitenden Flächen (4; 14) Teil eines einzelnen Sensorelementes ist.

7. Verwendung der Schutzstruktur (6) aus einem der elektronischen Bauelemente gemäß einem der vorhergehenden Ansprüche, als Schutzvorrichtung gegen elektrostatische Entladung.

## Claims

1. Electronic component having a dielectric layer (2) which is formed on a substrate (10), conductive areas (4; 14) which are formed on the dielectric layer, and an electrically conductive protective structure (6) which is arranged in a plane above the conductive areas (4; 14) in such a manner that the conductive areas (4; 14) are not completely covered by the protective structure (6) and the protective structure (6) is arranged along interspace regions (Z) which are formed between the conductive areas (4; 14), **characterized in that** the protective structure (6) runs, in the form of a strip, obliquely with respect to a propagation direction of the interspace region (Z).

2. Electronic component according to Claim 1, in which the direction in which the protective structure (6) in the form of a strip runs changes at the edge of the interspace region (Z) in such a manner that the interspace region (Z) is not left, or changes at the edge of the interspace region (Z).

3. Electronic component according to one of the preceding claims, in which the protective structure (6) is formed from tungsten.

4. Electronic component according to one of the preceding claims, in which the protective structure (6) has a structure width of 1 µm to 5 µm.

5. Electronic component according to one of the preceding claims, in which the protective structure (6) is in the form of a lattice.

6. Electronic component according to one of the preceding claims, in which one of the conductive areas (4; 14) is part of an individual sensor element.

7. Use of the protective structure (6) comprising one of the electronic components according to one of the preceding claims as an apparatus for protecting against electrostatic discharge.

## Revendications

1. Composant électronique comprenant une couche (2) diélectrique formée sur un substrat (10), des surfaces (4, 14) conductrices qui sont formées sur la couche diélectrique et une structure (6) de protection qui est conductrice de l'électricité et qui est disposée dans un plan au-dessus des surfaces (4, 14) conductrices de façon à ce que les surfaces (4, 14) conductrices soient recouvertes entièrement de la structure (6) de protection, la structure (6) de protection étant disposée le long de parties (Z) d'espace intermédiaire qui sont formées entre les surfaces (4, 14) conductrices, **caractérisé en ce que** la structure (6) de protection s'étend en forme de bande en étant inclinée par rapport à une direction d'extension de la partie (Z) d'espace intermédiaire.

2. Composant électronique suivant la revendication 1, dans lequel, aux bords de la partie (Z) d'espace intermédiaire, la direction suivant laquelle la structure (6) de protection en forme de bande s'étend est modifiée de façon à ce que la partie (Z) d'espace intermédiaire ne soit pas quittée ou se modifie au bord de la partie (Z) d'espace intermédiaire.

3. Composant électronique suivant l'une des revendications précédentes, dans lequel la structure (6) de protection est en tungstène.

4. Composant électronique suivant l'une des revendications précédentes, dans lequel la structure (6) de protection a une largeur de structure de 1 µm à 5 µm.

5. Composant électronique suivant l'une des revendications précédentes, dans lequel la structure (6) de protection est en forme de grille.

6. Composant électronique suivant l'une des revendications précédentes, dans lequel l'une des surfaces (4, 14) conductrices fait partie d'un élément individuel de capteur.

7. Utilisation de la structure (6) de protection constituée de l'un des composants électroniques suivant l'une des revendications précédentes comme dispositif de protection vis-à-vis d'une décharge électrostatique.
